Europäisches Patentamt

European Patent Office

Office européen des brevets

Publication number: **0 359 212**
**A2**

# EUROPEAN PATENT APPLICATION

(21) Application number: **89116893.2**

(22) Date of filing: **12.09.89**

(51) Int. Cl.5 **G06F 12/06**

(30) Priority: **13.09.88 JP 229022/88**

(43) Date of publication of application:
**21.03.90 Bulletin 90/12**

(84) Designated Contracting States:
**DE FR GB**

(71) Applicant: **KABUSHIKI KAISHA TOSHIBA**
**72, Horikawa-cho Saiwai-ku**
**Kawasaki-shi Kanagawa-ken 210(JP)**

(72) Inventor: **Gunji, Shizuka Intellectual Property**
**Division**
**K.K. TOSHIBA 1-1 Shibaura 1-chome**
**Minato-ku**
**Tokyo 105(JP)**

(74) Representative: **Henkel, Feiler, Hänzel &**
**Partner**
**Möhlstrasse 37**
**D-8000 München 80(DE)**

(54) Computer system capable of controlling access to expanded memory.

(57) In an information processing system having a paging mechanism in which a part of a memory address space of a CPU (110) is used as a page frame (90) and an expanded memory is accessed through this page frame (90), the size of the expanded memory of the system is checked upon initialization of the system, and an expanded memory set register (200, 202, ...) provided for each memory set (130, 132, ...) constituting the expanded memory is controlled on the basis of the check result, thereby preventing the CPU from accessing a specified memory set. The same I/O port addresses of the register (211, 221, ...) concerning the paging mechanism are prevented from being present in both the standard internal expanded memory (300) and an external expanded memory (400).

F I G. 2

## Computer system capable of controlling access to expanded memory

The present invention relates to a memory expanding system and, more particularly, to an information processing system including an expanded memory device of an EMS system.

Recently, as a memory size of a personal computer has been greatly increased, memory expanding systems of various types have been adopted. In an EMS (Expanded Memory Specification) system as one of expanded memory systems, a part of a memory address space of a CPU is used as a window, and an expanded memory is accessed through the window. This system is a specification developed by three companies, Lotus, Intel, Microsoft, and a memory card (board) suitable for the system is available from, e.g., Intel Co.

The EMS is constituted by hardware having a paging mechanism and software for controlling the hardware. This software is called an EMM (Expanded Memory Manager) and is a resident driver program which can be installed by a user.

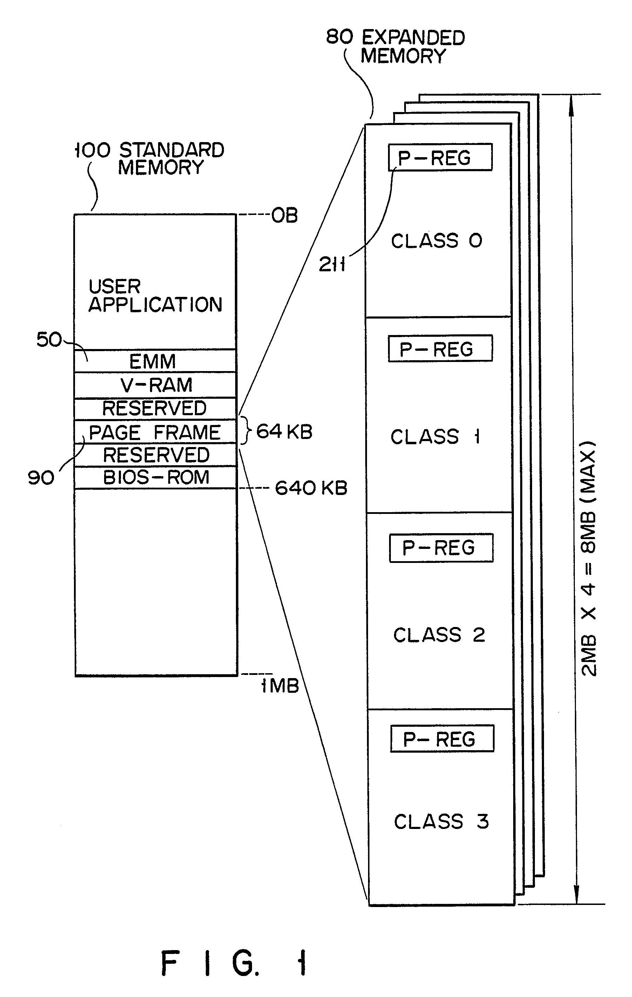

Fig. 1 shows a conventional memory map adopting the EMS system. An element 50 is the EMM described above. A part of a standard memory 100 which can be directly accessed by a CPU is used as an EMS window, and this EMS window is called a physical page. The size of one physical page is 16 K-bytes, and four pages continue. That is, an area of a total of 64 K-bytes is called a page frame. An element 90 is a page frame. An expanded memory 80 which is accessed through each physical page has units of 16 K-bytes and is called a logic page. The CPU can access a maximum of 512 pages (i.e., 16 K-bytes × 512 = 8 M-byte) via the page frame.

As for hardware, the expanded memory 80 is divided into units called sets and controlled in units of sets. One expanded memory system consists of a maximum of four sets, each set is constituted by four classes, and each class has one page control register.

Switching between the physical and logic pages is performed by writing a page number of the logic page in a page control register (P-REG) 211 in each class assigned to an I/O port address.

In the above conventional personal computer, however, if a standard internal expanded memory has 2 M-bytes and an external expanded memory included in commercially available EMS hardware is connected to the computer via a cable to increase a memory size, the same I/O port addresses of the page control register may be present in both the internal and external expanded memories. As a result, since memory areas in the internal and external expanded memories are used for the same data, a memory card cannot be effectively utilized. In addition, since the same data are present in two different memory sections at the same addresses when the expanded memories are used during execution of programs, the programs sometimes overrun.

It is an object of the present invention to provide an information processing system in which a memory size of the system can be increased by an external expanded memory included in commercially available EMS hardware and which can normally run programs corresponding to an EMS system.

In order to achieve the above object, according to a first aspect of the present invention, there is provided an information processing system for accessing a memory by a paging mechanism, comprising: a system bus for signal transfer between a CPU, an input/output (I/O) device, and a memory; an expanded memory consisting of a plurality of memory blocks; determining means for checking the size of the memory blocks equipped for the system, determining a desired one of the memory blocks to be connected to or unconnected from the system bus, and supplying a signal representing the determination result; and connection control means, provided for each memory block, for receiving the signal from the determining means and controlling connection/unconnection between the system bus and the memory blocks.

According to a second aspect of the present invention, there is provided a method of disabling or enabling access from a CPU with respect to a part of an expanded memory in an information processing system having a paging mechanism and including a system bus for signal transfer between the CPU, an input/output (I/O) device, and a memory, comprising the steps of: determining the size of the expanded memory equipped for the system; determining a size of the expanded memory to be used by a specific program; determining a desired part of the expanded memory to be connected to or unconnected from the system bus and supplying a signal representing the determination result; and receiving a signal generated in the supplying step and controlling connection/unconnection between the system bus and the desired expanded memory part.

According to the present invention, a size of the expanded memory of the system is checked upon initialization of the system, and an expanded memory set register provided for each memory block constituting the expanded memory is controlled on the basis of the check result, thereby preventing the CPU from accessing a specified memory block. Therefore, since the same I/O port addresses of a register concerning a paging mechanism are not present in the standard internal expanded memory and an optional external expanded memory, the expanded memory can be effectively used.

These and other features of the invention will become apparent in the following description of a preferred embodiment taken in conjunction with the accompanying drawings wherein:

Fig. 1 is a schematic view showing a conventional memory arrangement in which an EMS system is adopted;

Fig. 2 is a block diagram showing an information processing system according to the present invention; and

Fig. 3 is a flow chart showing an operation of an embodiment of the present invention.

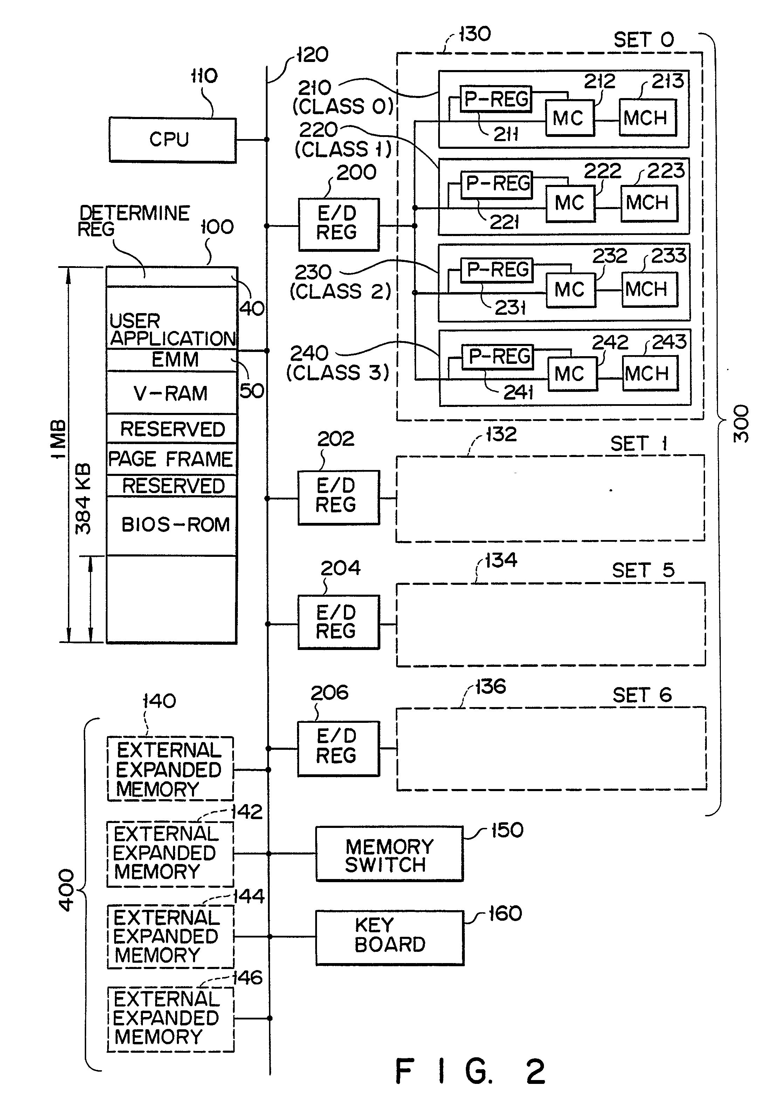

Fig. 2 is a block diagram of a system according to an embodiment of the present invention. Referring to Fig. 2 an element 110 is a central processing unit (CPU) for controlling the overall system, and an element 120 is a system bus. An element 100 is a main memory as a standard memory of the system and has a size of 1 MB (1,024 KB). Of 1 MB, 640 KB are assigned as a system memory, and the remaining (1,024 KB - 640 KB = 384 KB) can be used as an expanded memory. An element 130 is one set (block) of a standard internal expanded memory. Each set has 128 logic pages, and an EMM (50) can manage a maximum of four expanded memory sets.

The inside expanded memory set 130 is constituted by a class 0 210, a class 1 220, a class 2 230, and a class 3 240. The classes 210, 220, 230, and 240 are constituted by page control registers 211, 221, 231, and 241, memory controllers (MC) 212, 222, 232, and 242, and memory chips 213, 223, 233, and 243, respectively. When the EMM writes a page number in the page control register, the MC converts a relative address of the MCH into an absolute address corresponding to an address assigned to a page frame. As a result, the CPU can access each page of the expanded memory.

An element 150 is a memory switch which is a nonvolatile memory in which an operator sets the internal expanded memory size to be used by an application program in accordance with an EMS system and the like by using a keyboard 160.

As indicated by dotted lines, a maximum of four internal expanded memory sets can be connected to the system. In addition, an external expanded memory set 140 can be connected to the system via the system bus 120. Similar to the inside expanded memory set 130, the external expanded memory set 140 has page control registers, memory controllers, and memory chips. As indicated by dotted lines, a maximum of four external expanded memory sets can be connected to the system.

Expanded memory set registers (E/D REG) 200, 202, 204 and 206 are provided between the internal expanded memory sets 130, 132, 134 and 136, and the system bus 120 respectively. The page control registers 211, 221, 231, and 241 are enabled or disabled by the expanded memory control register. When the same addresses are present in the external and internal expanded memories, the internal expanded memory set is disabled by a signal from the CPU 110. That is, the memory set in which the same address is present is unconnected from the system bus. The disabled set cannot be accessed by the CPU 110. Therefore, when the same I/O port addresses of the page control register are present in both the external and internal expanded memories, an I/O port of the page control register of the external expanded memory is accessed by the CPU 110.

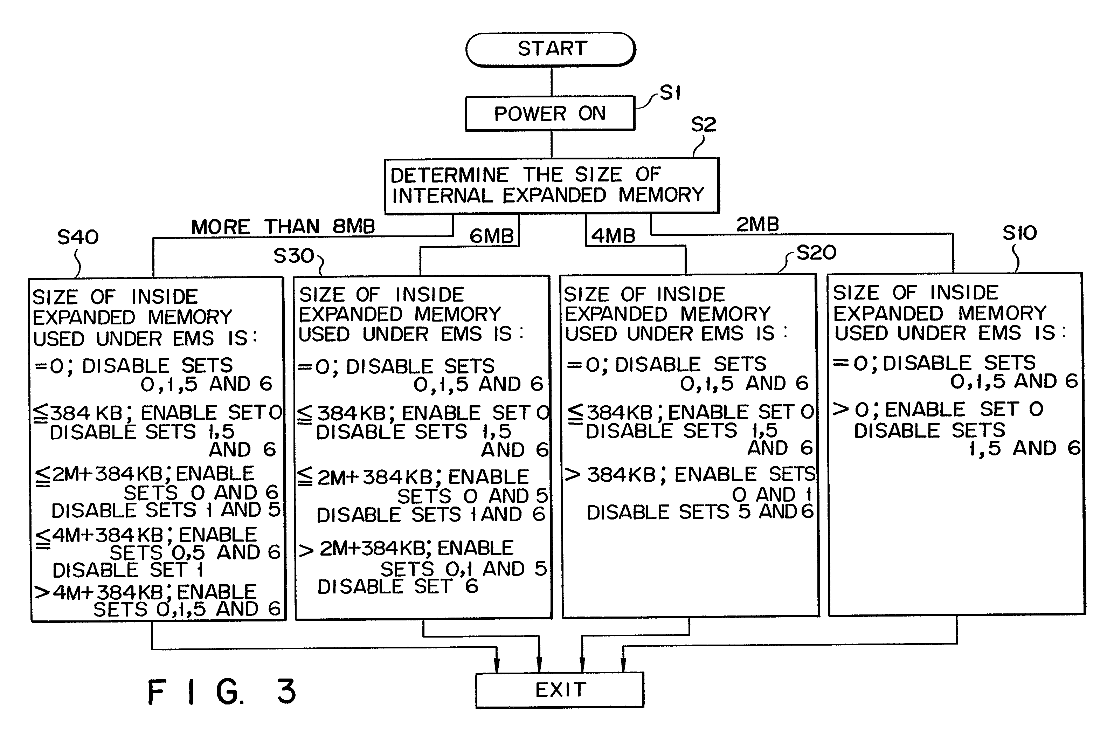

An operation of the embodiment of the present invention will be described below. Fig. 3 is a flow chart for explaining a method of setting enable data or disable data of the internal expanded memory set in the E/D REG upon initialization of the system (this set routine is shown in Fig. 2 as the element 40). After power is turned on (step S1), the size of the inside expanded memory is determined (step S2). The size of the inside expanded memory to be used for EMS programs is checked. This size can be determined by checking a value set up by the user in the memory switch 150. As a result of this memory check, the E/D REG is set in one of the following states in accordance with the size.

(1) If the inside expanded memory size is 2 MB (step S10):

(1a) If the size of the inside expanded memory to be used for the EMS programs = 0; disable data is loaded in all of the E/D REGs of the sets 0, 1, 5, and 6. In this case, none of the memory sets 0, 1, 5, and 6 can be used as an expanded memory.

(1b) If the size of the inside expanded memory to be used for the EMS programs > 0; enable data is loaded in the E/D REG of the set 0, and disable data is loaded in the E/D REGs of the sets 1, 5, and 6. In this case, the internal expanded memory of 0 to 2 MB can be used.

(2) If the internal expanded memory size is 4 MB (step S20):

(2a) If the size of the inside expanded memory to be used for the EMS programs = 0; the same as item (1a) above.

(2b) If the size of the inside expanded memory to be used for the EMS programs ≤ 384 KB; the same as item (1b) above.

(2c) If the size of the inside expanded memory to be used for the EMS programs > 384 KB;
enable data is loaded in the E/D REGs of the sets 0 and 1, and disable data is loaded in the E/D REGs of the sets 5 and 6. In this case, the internal expanded memories of 0 to 4 MB can be used.

(3) If the internal expanded memory size is 6 MB (step S30):

(3a) If the size of the inside expanded memory to be used for the EMS programs = 0;
the same as item (1a) above.

(3b) If the size of the inside expanded memory to be used for the EMS programs ≦ 384 KB;
the same as item (1b) above.

(3c) If the size of the inside expanded memory to be used for the EMS programs ≦ 2 M + 384 KB;
enable data is loaded in the E/D REGs of the sets 1 and 5, and disable data is loaded in the E/D REGs of the sets 1 and 6. In this case, the internal expanded memory of 0 to 2 MB and 4 to 6 MB can be used.

(3d) If the size of the internal expanded memory to be used for the EMS programs > 2M + 384 KB;
enable data is loaded in the E/D REGs of the sets 0, 1, and 5, and disable data is loaded in the E/D REG of the set 6. In this state, the internal expanded memory of 0 to 6 MB can be used.

(4). If the inside expanded memory size is 8 MB (step S40):

(4a) If the size of the internal expanded memory to be used for the EMS programs - 0;
the same as item (1a) above.

(4b) If the size of the internal expanded memory to be used for the EMS programs ≦ 384 KB;
the same as item (1b) above.

(4c) If the size of the internal expanded memory to be used for the EMS programs ≦ 2M + 384 KB;
enable data is loaded in the E/D REGs of the sets 0 and 6, and disable data is loaded in the E/D REGs of the sets 1 and 5. In this case, the internal expanded memory of 0 to 2 MG and 6 to 8 MB can be used.

(4d) If the size of the internal expanded memory to be used for the EMS programs ≦ 4 M + 384 KB;
enable data is loaded in the E/D REGs of the sets 0, 5, and 6, and disable data is loaded in the E/D REG of the set 1. In this case, the internal expanded memory of 0 to 2 MB and 4 to 8 MB can be used.

(4e) If the size of the internal expanded memory to be used for the EMS programs 4 M + 384 KB;

enable data is loaded in the E/D REGs of the sets 0, 1, 5, and 6. In this case, the internal expanded memory of 0 to 8 MB can be used.

An operation will be described below assuming that a certain process P1 of the application programs uses an expanded memory of three logic pages (48 KB).

(1) The process P1 requests use of three logic pages to the EMM.

(2) The EMM searches currently non-used logic pages (#0 to #2) and assigns them to the process PI.

(3) The process P1 sends, to the EMM, information representing that which physical pages #0 to #3 are mapped to which assigned logic pages #0 to #2. For example, the process P1 sends, to the EMM, information representing that the logic page #0 is mapped to the physical page #0.

(4) In response to this information, the EMM updates the value of the corresponding page control register. At this time, even if the internal and external expanded memories have the same I/O port address of the page control register, writing in the page control register of the inside expanded memory is inhibited by the above method of the present invention. Therefore, one physical page is not simultaneously connected to two logic pages.

In this manner, the process P1 can access the logic pages #0 to #2 in the internal memory via the physical pages in the standard memory 100.

**Claims**

1. An information processing system which has a paging mechanism, a system bus (120) for signal transfer between a central processing unit (CPU) (110), an input/output (I/O) device, and a memory, and an expanded memory consisting of a plurality of memory blocks (130, 132, ..., 140, 142, ...), comprising:
determining means (40) for checking the size of said plurality of memory blocks (130, 132, ..., 140, 142, ...) equipped for the system, determining a desired one of said memory blocks to be connected to or unconnected from said system bus (120), and supplying a signal representing the determination result; and
connection control means (200, 202, ...), provided for each of said memory blocks (130, 132, ..., 140, 142, ...), for receiving the signal from said determining means (40) and controlling connection/unconnection between said system bus (120) and said memory blocks (130, 132, ..., 140, 142, ...).

2. A system according to claim 1, characterized in that said expanded memory consists of a plurality of expanded memory groups (300, 400, ...), and said connection control means (200, 202, ...) controls a specific expanded memory group of said plurality of expanded memory groups (300, 400, ...).

3. A system according to claim 1, characterized in that said determining means (40) includes means for checking a size of said memory blocks (130, 132, ..., 140, 142, ...) to be used for a specific program.

4. A method of disabling or enabling access from a central processing unit (CPU) (110) with respect to a part of an expanded memory in an information processing system having a paging mechanism, a system bus (120) for signal transfer between said CPU (110), an input/output device (I/O), and a memory, and an expanded memory consisting of a plurality of memory blocks (130, 132, ..., 140, 142, ...), comprising the steps of:
determining a size of said expanded memory equipped for the system;
determining a size of said expanded memory to be used by a specific program;
determining a desired part of said expanded memory to be connected to or unconnected from said system bus (120) and supplying a signal representing the determination result; and
receiving the signal generated in said supplying step and controlling connection or unconnection between said system bus (120) and said desired expanded memory part.

F I G. 1

EP 0 359 212 A2

F I G. 2

```
                    ┌─────────────┐
                    │    START    │
                    └──────┬──────┘
                           │
                    ┌──────┴──────┐
                    │  POWER ON   │ S1
                    └──────┬──────┘
                           │            S2
              ┌────────────┴────────────┐
              │  DETERMINE THE SIZE OF   │
              │ INTERNAL EXPANDED MEMORY │
              └──────────────────────────┘
```

MORE THAN 8MB        6MB        4MB        2MB

S40                  S30                   S20              S10

**SIZE OF INSIDE EXPANDED MEMORY USED UNDER EMS IS:**

=0; DISABLE SETS 0,1,5 AND 6

≦384 KB; ENABLE SET 0 DISABLE SETS 1,5 AND 6

≦2M+384KB; ENABLE SETS 0 AND 6 DISABLE SETS 1 AND 5

≦4M+384KB; ENABLE SETS 0,5 AND 6 DISABLE SET 1

>4M+384KB; ENABLE SETS 0,1,5 AND 6

**SIZE OF INSIDE EXPANDED MEMORY USED UNDER EMS IS:**

=0; DISABLE SETS 0,1,5 AND 6

≦384KB; ENABLE SET 0 DISABLE SETS 1,5 AND 6

≦2M+384KB; ENABLE SETS 0 AND 5 DISABLE SETS 1 AND 6

>2M+384KB; ENABLE SETS 0,1 AND 5 DISABLE SET 6

**SIZE OF INSIDE EXPANDED MEMORY USED UNDER EMS IS:**

=0; DISABLE SETS 0,1,5 AND 6

≦384KB; ENABLE SET 0 DISABLE SETS 1,5 AND 6

>384KB; ENABLE SETS 0 AND 1 DISABLE SETS 5 AND 6

**SIZE OF INSIDE EXPANDED MEMORY USED UNDER EMS IS:**

=0; DISABLE SETS 0,1,5 AND 6

>0; ENABLE SET 0 DISABLE SETS 1,5 AND 6

```
                    ┌─────────────┐
                    │    EXIT     │
                    └─────────────┘
```

F I G. 3

EP 0 359 212 A2